# EUROPEAN PATENT APPLICATION

(11) **EP 4 350 219 A1**
(43) Date of publication of application: **10.04.2024**
(21) Application number: 22811687.7
(22) Date of filing: 27.05.2022
(51) Int. Cl.: F24C 15/00, H05B 6/12, H05K 7/20

(54) **ELECTRIC RANGE**

(30) Priority: 28.05.2021 KR 20210069399; 10.08.2021 KR 20210105139
(71) Applicant: LG Electronics Inc., Yeongdeungpo-gu Seoul 07336 (KR)
(72) Inventor: KIM, Hyunsoo, Seoul 08592 (KR); CHO, Junghyeon, Seoul 08592 (KR); PARK, Myoeng Soo, Seoul 08592 (KR); LEE, Ji Won, Seoul 08592 (KR); KIM, Mijung, Seoul 08592 (KR)
(74) Representative: Vossius & Partner Patentanwälte Rechtsanwälte mbB
(86) International application number: PCT/KR2022/007574
(87) International publication number: WO 2022/250496

(57) **Abstract**

An electric range is disclosed. The disclosed electric range may increase the cooling efficiency of a heat sink and some electronic devices by placing the heat sink and some electronic devices inside one air guide. The electric range according to one embodiment may comprise: a printed circuit board having a plurality of electronic devices mounted thereon; a heat sink mounted on the printed circuit board; a blower fan for discharging air; and the air guide surrounding some electronic devices from among the plurality of electronic devices and the heat sink, communicating with the blower fan, and forming a flow path for the air discharged from the blower fan.

## Description

### [Technical Field]

The present disclosure relates to an electric range, and more specifically to an electric range having a structure capable of effectively cooling an inside of the electric range.

### [Background Art]

In homes or restaurants, various types of cooking utensils for heating food are used. The cooking utensils include a gas stove using gas and an electric range using electricity.

An electric range is roughly divided into a resistance heating type electric range and an induction heating type electric range.

The resistance heating type electric range generates heat by applying a current to a metal resistance line or a nonmetal heating element such as silicon carbide, and heats an object to be heated (e.g. a cooking vessel such as a pot or frying pan) by radiating or conducting the generated heat.

The induction heating type electric range generates a magnetic field around a coil by applying high frequency power to the coil, and heats an object to be heated made of a metallic material, by using an eddy current generated from the generated magnetic field.

The basic principle of induction heating is as follows. When current is applied to a working coil or a heating coil, heat is generated through induction heating of the object to be heated, and the object to be heated is heated by the generated heat.

As a conventional art related to this, Korea Registered Patent No. 1,291,428 discloses a cooking appliance that operates by induction heating.

A conventional cooking appliance includes an inductive heating unit, an inverter module that supplies power to the inductive heating unit, a heat sink to which a heat-generating electric device of the inverter module, a cooling fan connected to one end of the heat sink, and a flow guide disposed on one side of the heat sink. Here, the flow guide guides a portion of the cooling air discharged from the cooling fan in the direction where the heat-generating electric device is disposed.

However, the conventional technology has the disadvantage that it is difficult to cool the heat-generating electric device located outside the flow guide.

### [Disclosure]

### [Technical Problem]

An object of the present disclosure is to provide an electric range having a structure that can effectively suppress overheating of a printed circuit board mounted inside and increase the cooling efficiency of the printed circuit board.

In addition, an object of the present disclosure is to provide an electric range having a structure capable of effectively cooling a heat sink and electronic devices mounted therein.

In addition, an object of the present disclosure is to provide an electric range having a structure capable of cooling a heat sink, electronic devices provided in the heat sink, and electronic devices provided outside the heat sink together.

In addition, an object of the present disclosure is to provide an electric range having a structure that can separately provide an air flow path for cooling a heat sink and an air flow path for cooling electronic devices provided outside the heat sink.

In addition, an object of the present disclosure is to provide an electric range having a structure that effectively cools the entire printed circuit board by forcing air to flow using an air blower fan mounted therein.

Objectives of the present disclosure are not limited to what has been described. Additionally, other objectives and advantages that have not been mentioned may be clearly understood from the following description and may be more clearly understood from embodiments.

### [Technical Solution]

An electric range according to an embodiment of the present disclosure can increase the cooling efficiency of a heat sink and some electronic devices by disposing the heat sink and some electronic devices in one air guide.

In addition, an electric range according to an embodiment of the present disclosure can effectively cool both a heat sink and some electronic devices by forming a first flow path of air which cools the heat sink and a second flow path of air which cools some electronic devices in an air guide, respectively.

In addition, an electric range according to an embodiment of the present disclosure can effectively cool both a heat sink and some electronic devices by separately forming a first flow path of air which cools the heat sink and a second flow path of air which cools some electronic devices in an air guide.

In addition, in an electric range according to an embodiment of the present disclosure, air can effectively flow into a second flow path by forming a portion of a side wall of an air guide which forms the second flow path of air to be inclined.

In addition, in an electric range according to an embodiment of the present disclosure, interference with other components mounted on a printed circuit board can be prevented by forming a second part of an air guide, which forms a second flow path of air, to be stepped, based on a first part of the air guide which forms a first flow path of air.

In addition, an electric range according to an embodiment of the present disclosure may include a case, a cover plate which is coupled to the upper end of the case, a heater which is disposed on the lower portion of the cover plate, an upper bracket which is disposed on the lower portion of the heater and supports the heater, a base bracket which is disposed on the lower portion of the upper bracket and on which a printed circuit board equipped with a plurality of electronic devices is mounted is installed, a heat sink which is installed on the printed circuit board, an air blowing fan which is installed on the base bracket and discharges air, and an air guide which is mounted on the printed circuit board to surround some of the plurality of electronic devices and the heat sink, communicates with the air blower fan, and forms a flow path of the air discharged from the air blower fan. Here, the air flow path may include a first flow path for cooling the heat sink and a second flow path for cooling some of the electronic devices.

In addition, an electric range according to another embodiment of the present disclosure may include a case, a heater which is disposed inside the case, a base bracket which is disposed on the lower portion of an upper bracket and on which a printed circuit board equipped with a plurality of electronic devices is mounted is installed, a heat sink which is mounted on the printed circuit board, an air blower fan which is installed on the base bracket and discharges air, and an air guide which is mounted on the printed circuit board to surround some of the electronic devices and the heat sink, communicates with the air blower fan, and forms a flow path of the air discharged from the air blower fan. Here, the air guide may include a first part and a second part protruding from one side of the first part, the heat sink may be disposed in the first part, and some of the electronic devices may be disposed in the second part.

### [Advantageous Effects]

According to the present disclosure, by forming a separate air flow path for each of the heat sink and some electronic devices included in the air guide, it is possible to effectively cool the electronic devices where overheating mainly occurs. As a result, overheating of printed circuit boards can be effectively prevented.

In addition, according to the present disclosure, by forming a portion of the side wall of the second flow path of air for cooling some of the electronic devices to be inclined, air can effectively flow into the second flow path, thereby increasing the cooling efficiency of some of the electronic devices.

In addition, according to the present disclosure, by forming the second flow path of air for cooling some of the electronic devices in a stepped manner, interference with other components mounted on the printed circuit board can be prevented, thereby increasing assembly efficiency.

Detailed effects of the present disclosure are described together with the above-described effects in the detailed description of the disclosure.

### [Description of Drawings]

FIG. **1** a perspective view of an electric range according to an embodiment.
FIG. 2 is a perspective view of FIG. 1 where a cover plate is omitted.
FIG. 3 is an exploded view of FIG. 1.
FIG. 4 is a perspective view of FIG. 1 where a cover plate, a heater, and an upper bracket are omitted.
FIG. 5 is a plan view of FIG. 4.
FIG. 6 is a perspective view illustrating a state in which a printed circuit board is mounted on a base bracket 50 according to one embodiment.
FIG. 7 is a plan view of FIG. 6.
FIG. 8 is a perspective view of a heat sink according to an embodiment.
FIG. 9 is a front view of FIG. 8.
FIG. 10 is a perspective view of a base bracket according to an embodiment.
FIG. 11 is a plan view of FIG. 10.
FIG. 12 is a perspective view of a case according to an embodiment.
FIG. 13 is a plan view of FIG. 12.
FIG. 14 is a perspective view of an air guide according to a first embodiment.
FIG. 15 is a perspective view of FIG. 14 viewed from a different direction.
FIG. 16 is a plan view of FIG. 14.
FIG. 17 is a plan view illustrating a flow path of air inside and outside an air guide according to an embodiment.
FIGS. 18 and 19 are diagrams for explaining a simulation according to an embodiment.

### [Mode for Invention]

The above-described objectives, features and advantages are described in detail with reference to the attached drawings. In describing the disclosure, detailed description of known technologies in relation to the disclosure is omitted if it is deemed to make the gist of the present disclosure unnecessarily vague.

Although first, second, and the like are used to describe various components, these terms are only used to distinguish a component from another component. Through the specification, each element may be singular or plural unless particularly described otherwise. Throughout the specification, terms such as "consisting of' or "including" should not be interpreted as necessarily including all of various elements or various steps described herein and should be interpreted as indicating that additional elements or steps may be further included.

Throughout, an "upward-downward direction" denotes an upward-downward direction of an electric range in a state in which the electric range is installed for use. A "leftward-rightward direction" denotes a direction orthogonal to the upward-downward direction, and a "frontward-rearward direction" denotes a direction orthogonal to the upward-downward direction and the leftward-rightward direction. "Both lateral directions" or a "lateral direction" may have the same meaning as the leftward-rightward direction. These terms can be mixedly used herein.

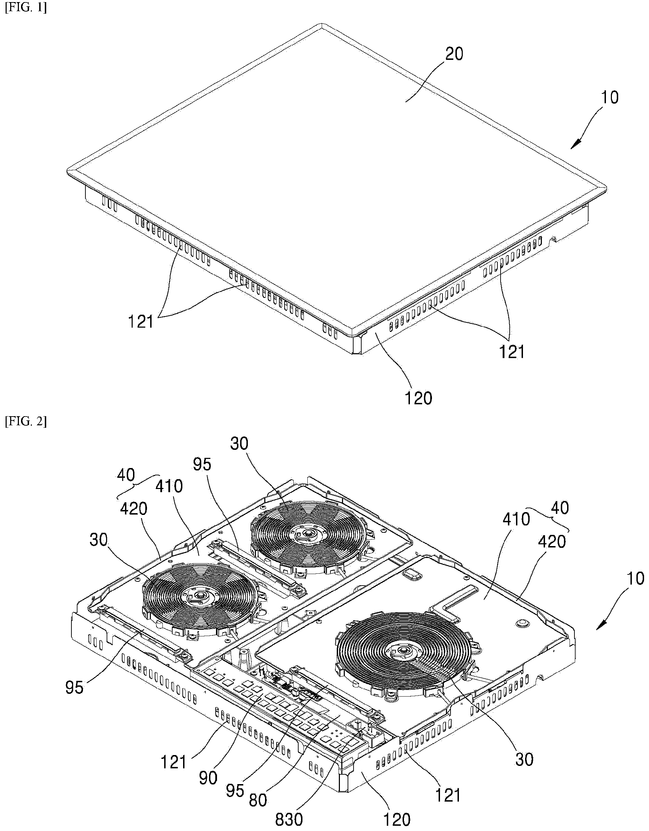

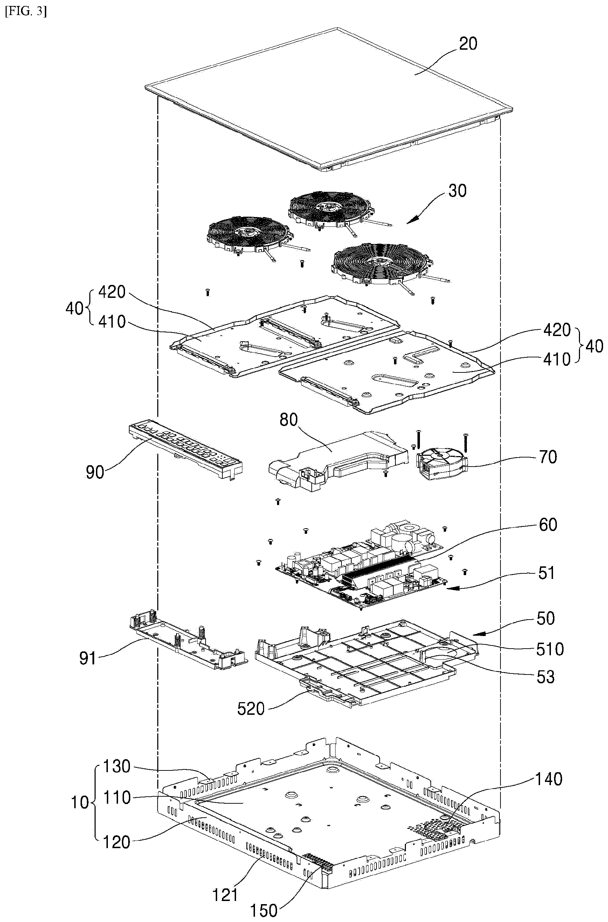

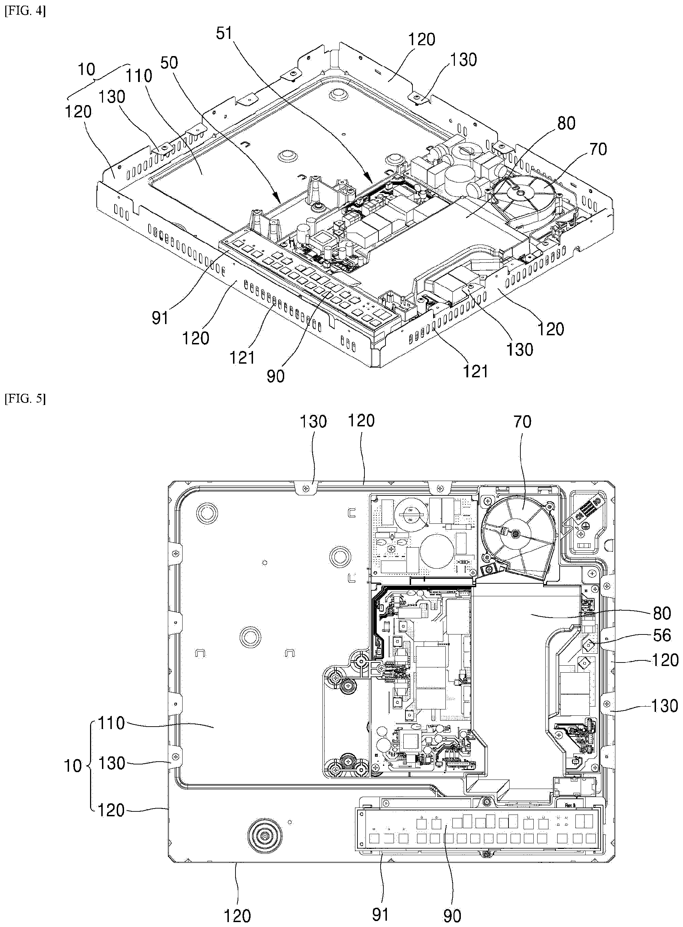

FIG. 1 a perspective view of an electric range according to an embodiment. FIG. 2 is a perspective view of FIG. 1 where a cover plate 20 is omitted. FIG. 3 is an exploded view of an electric range according to an embodiment. FIG. 4 is a perspective view of FIG. 1 where the cover plate 20, a heater 30, and an upper bracket 40 are omitted. FIG. 5 is a plan view of FIG. 4.

An electric range according to an embodiment may heat an object to be heated based on induction heating. In this case, an object to be heated may be a tableware containing a metal material such as stainless steel or iron.

The induction heating method includes supplying high-frequency power to a working coil to generate a magnetic field around the working coil, and heating an object to be heated made of metal, using eddy current produced by the generated magnetic field.

That is, as high-frequency power is supplied to a heating unit or heater 30 having a structure in which the working coil is adjacent to a ferrite core, a magnetic field is generated around the working coil. As an object to be heated is placed in an area of the generated magnetic field, eddy current is induced to the object to be heated by the magnetic field, and Joule's heat is generated by the eddy current, thereby heating the object to be heated. As the object to be heated is heated, a food item contained in the object to be heated is heated and cooked.

An electric range according to an embodiment may include a case 10, a cover plate 20, the heater 30, an upper bracket 40, and a base bracket 50.

The case 10 may protect components constituting the electric range. For example, the case 10 may be made of aluminum, but is not limited thereto.

Meanwhile, the case 10 may be thermally insulated to suppress the release of heat generated by the working coil of the heater 30 to the outside.

The case 10 may store components, such as the heater 30, the working coil, the upper bracket 40, and a control board 90 that constitute the electric range. An upper portion of the case 10 may be open. The open portion may be closed by the cover plate 20. The case 10 may be entirely formed into a box by processing plate-shaped materials.

The case 10 may include a first casing 110, a second casings 120, and a third casing 130.

The first casing 110 may form a bottom surface of the case 10. The first casing 110 may support built-in components of the above described electric range.

A printed circuit board 51 may be provided inside the first casing 110. In addition, the first casing 110 may be provided with at least one vent hole through which air flows to facilitate cooling of electronic device components mounted on the printed circuit board 51.

The second casing 120 may be bent from the first casing 110 and may form a side surface of the case 10. The second casing 120 may be bent from an edge of the first casing 110 in an upward-downward direction to form a side wall of the electric range.

The second casing 120 may be disposed on each side of the first casing 110 formed in a substantially quadrangular shape. The second casing 120 may reinforce a strength of an entirety of the case 10.

That is, the second casing 120 may be formed to be bent from the first casing 110 to suppress the first casing 110 having a plate shape from being warped or damaged due to a weight of the built-in components or an external force.

The second casing 120 may further include a plurality of exhaust holes 121 formed in slit shapes. The exhaust holes 121 may allow an inside and outside of the case 10 to communicate with each other. Accordingly, since air flows through the exhaust holes 121, the components accommodated in the case 10 can be cooled. The third casing 130 may be bent from the second casing 120 and may support the upper bracket 40. The third casing 130 may be disposed on each side of the first casing 110.

A first upper plate 410 forming a bottom surface of the upper bracket 40 may be seated on an upper surface of the third casing 130. The first upper plate 410 and the third casing 130 may be coupled by a coupling unit, such as a bolt.

The cover plate 20 may be coupled to an upper end of the case 10. The cover plate 20 may close the open upper portion of the case 10 to protect the components accommodated in the case 10.

An object to be heated may be placed on the upper surface of the cover plate 20, and a magnetic field generated by the heater 30 may pass through the cover plate 20 and reach the object to be heated. The cover plate 20 may be formed of a material containing, for example, a ceramic, but is not limited thereto.

An input interface through which an input is received from a user may be installed on the upper surface of the cover plate 20. The input interface may be installed in a specific region of the upper surface of the cover plate 20 and may display a specific image.

A touch input may be received from the user through the input interface, and the electric range may be driven on the basis of the received touch input.

For example, the input interface may be a module for a user to input a desired heating intensity or heating time and may be implemented as a physical button, or touch panel.

For example, the input interface may be a thin film transistor liquid crystal display (TFT LCD), but is not limited thereto.

The control board 90 which inputs an operation command to the electric range may be provided on a lower portion of the cover plate 20. A plurality of key switches may be provided on the control board 90. The user may input a command to the control board 90 through the plurality of key switches to control operation of the electric range.

In an electric range according to an embodiment, a board support 91 may be provided to stably install the control board 90 in the case 10. The board support 91 may be installed in the case 10, and the control board 90 may be installed on the board support 91.

The board support 91 may be manufactured in a shape that allows the board support 91 and the control board 90 to be stably installed. The board support 91 may be formed of a plastic material, which is electrically insulative and is easily injection-molded, in order to be easy to manufacture, light, and electrically insulative, but the material is not limited thereto.

In an electric range according to an embodiment, an upper surface of the control board 90 may be provided to be pressed against a lower surface of the cover plate 20. In this case, the control board 90 may be disposed at a location corresponding to the input interface.

In this case, the control board 90 and the input interface may be connected to each other in a capacitive touch input manner. Accordingly, when the user inputs a control command through the input interface, the control command may be input to the control board 90.

In addition, a display on which a drive state of the electric range is displayed may be provided in a specific region of the upper surface of the cover plate 20.

A light display region may be formed in the upper surface of the cover plate 20. Alight source unit 95 may be disposed on a lower surface of the cover plate 20, and light emitted by the light source unit 95 may be transmitted to the user through the light display region.

In this case, the light display region and the light source unit 95 may be disposed at locations corresponding to each other. When a plurality of light source units 95 is provided, light display regions equal in number to the light source units 95 may also be provided in the upper surface of the cover plate 20.

An electric range according to an embodiment may further include a cover bracket that supports the cover plate 20. An upper surface of the cover bracket may support the cover plate 20, and the cover bracket may be coupled to the second casing 120 of the case 10 by a coupling unit, such as a screw bolt.

The A plurality of heater 30 may be provided, and the plurality of heaters 30 may be disposed on a lower surface of the cover plate 20, and may heat an object to be heated.

According to an embodiment, the plurality of heaters 30 may be provided to operate through an induction method.

According to another embodiment, some of the plurality of heaters 30 may be provided to operate through an induction heating method, while the rest of the plurality of heaters 30 may be provided to operate through an electric resistance heating method. That is, an electric range may be provided as a highlight heater or a hybrid range.

Hereinafter, an electric range in which all the plurality of heaters 30 is provided to operate through the induction heating method will be described.

The heater 30 may be installed on the upper bracket 40, and in this embodiment, a total of three heaters 30 may be provided. Apparently, the number of the heaters 30 is not limited thereto. When the plurality of heaters 30 is provided, the upper bracket 40 that supports the heaters 30 may also be provided as a plurality of upper brackets 40 as necessary.

The heater 30 may include a core frame, the working coil may be spirally wound on an upper surface of the core frame, and the ferrite core may be installed on a lower surface of the core frame. Accordingly, when high frequency power is applied to the working coil, a magnetic field may be generated around the ferrite core, and the generated magnetic field may generate an eddy current in an object to be heated.

The upper bracket 40 may be disposed on a lower portion of the heater 30 and may support the heater 30. In this embodiment, the upper bracket 40 may be provided as the plurality of upper brackets 40. For example, the upper bracket 40 may be formed of an aluminum material, but is not limited thereto.

The upper bracket 40 may be manufactured as a structure that supports the heater 30 by processing a plate metal in substantially a box shape.

The upper bracket 40 may include a first upper plate 410 and a second upper plate 420. The first upper plate 410 may form the bottom surface of the upper bracket 40, and the heater 30 may be installed on the first upper plate 410.

The first upper plate 410 may hide the printed circuit board 51 provided thereunder in the upward-downward direction. When the plurality of upper brackets 40 is provided, one first upper plate 410 or a plurality of first upper plates 410 combined with each other may hide the printed circuit board 51 according to an area of the printed circuit board 51.

Due to this structure, the first upper plate 410 may serve to block an electromagnetic field and electromagnetic waves generated by the heater 30 from reaching the printed circuit board 51 and devices mounted on the printed circuit board 51.

That is, the upper bracket 40 may serve to improve the performance of electromagnetic compatibility (EMC) and electromagnetic interference (EMI) for the printed circuit board 51.

The second upper plate 420 may be bent from the first upper plate 410 in the upward-downward direction of the electric range. The second upper plate 420 may be formed to be bent from an edge of the first upper plate 410 in the upward-downward direction.

The second upper plate 420 may be disposed on each side of the first upper plate 410 formed in a substantially quadrangular shape. When the plurality of upper brackets 40 is provided, the second upper plate 420 may be provided on the respective sides of the first upper plate 410 excluding sides adjacent to each other of the upper brackets 40.

The second upper plate 420 may reinforce a strength of an entirety of the upper bracket 40. That is, the second upper plate 420 may be formed to be bent from the first upper plate 410 to suppress warping of or damage to the first upper plate 410 due to a weight of built-in components including the heater 30 or an external force.

The light source unit 95 may be disposed on the upper bracket 40. For example, the light source unit 95 may be provided on the printed circuit board 51 disposed on a lower portion of the upper bracket 40, and an opening disposed at a location corresponding to the light source unit 95 may be formed in the upper bracket 40.

As another embodiment, light source unit 95 may be disposed on upper bracket 40, and the light source unit 95 may also be electrically connected to printed circuit board 51 disposed thereunder. In FIGS. 2 and 3, a structure in which the light source unit 95 is disposed on the upper bracket 40 is illustrated as an example of an electric range.

As described above, the light display region may be formed on the cover plate 20 at a portion corresponding to the light source unit 95. For example, the light source unit 95 may be provided in a form in which a plurality of light emitting diodes (LEDs) is arranged in a line.

When the heater 30 operates, the light source unit 95 may be turned on to notify the user of whether the heater 30 is operated. Alternatively, the light source unit 95 may also change a lighting shape, color, or the like of the plurality of LEDs to notify the user of a state in which the electric range is operating.

A number of the light source units 95 may be properly selected according to the number of the heater 30. In FIGS. 2 and 3 , three light source units 95 are provided to correspond to three heaters 30. However, the number of the light source units 95 is not limited thereto.

The base bracket 50 may be disposed on a lower portion of the upper bracket 40, and the printed circuit board 51 may be installed on the base bracket 50. The base bracket 50 may include a bottom plate and a side plate.

The bottom plate may form a bottom surface of the base bracket 50, and the printed circuit board 51 may be installed on an upper surface of the base bracket 50.

The side plate may be bent from the bottom plate in the upward-downward direction of the electric range. The side plate may be bent from an edge of the bottom plate in the upward-downward direction.

The side plate may be disposed on each side of the bottom plate formed in a substantially quadrangular shape. When the plurality of upper brackets 40 is provided, the side plate may be formed on the sides of the bottom plate excluding sides adjacent to each other of the upper bracket 40.

The side plate may reinforce a strength of an entirety of the base bracket 50. That is, the side plate may be formed to be bent from the bottom plate to suppress the bottom plate having a board shape from being warped or damaged due to a weight of built-in components, such as the circuit board, or an external force.

The base bracket 50 may be formed of a plastic material, which is electrically insulative and is easily injection-molded, in order to be easy to manufacture, light, and electrically insulative, but the material is not limited thereto.

The printed circuit board 51 may constitute a controller. The printed circuit board 51 may receive power from an external power source and may be provided to communicate with an external device in a wired or wireless manner.

A wireless communication circuit board (WiFi PCB) may be installed in the electric range in order to wirelessly communicate with an external device. The printed circuit board 51 may be electrically connected to the wireless communication circuit board.

The printed circuit board 51 may be electrically connected to the control board 90 and may receive a command input by the user from the control board 90. The printed circuit board 51 may be electrically connected to the light source unit 95 and the working coil and may control operation of the light source unit 95 and the working coil.

A heat sink 60 may be mounted on the printed circuit board 51. A plurality of electronic devices for operation of the electric range may be mounted. Accordingly, a drive circuit for driving the heater 30 may be formed on the printed circuit board 51.

A plurality of electronic devices may generate heat when an electric range is operated. For example, the drive circuit includes a plurality of electronic devices such as a rectifier, a DC link capacitor, an inverter, a resonance capacitor, a snubber capacitor, a shunt resistor, etc., and the plurality of electronic devices may generate heat during operation. If the temperature of a plurality of electronic devices is high, the electric range may stop working or malfunction.

Accordingly, an electric range may further include the heat sink 60, an air blower fan 70, and an air guide 80 to cool a plurality of electronic devices.

The heat sink 60 may cool heat inside of the case 10 to protect the electronic devices accommodated in the case 10. The heat sink 60 may be mounted on the printed circuit board 51. In addition, the heat sink 60 may cool heat generated due to an electromagnetic interaction when the heater 30 operates.

The air blower fan 70 may be installed on the base bracket 50 and may be provided to discharge air toward the heat sink 60. The air blower fan 70 may be electrically connected to the printed circuit board 51, and operation of the air blower fan 70 may be controlled by the controller implemented on the printed circuit board 51.

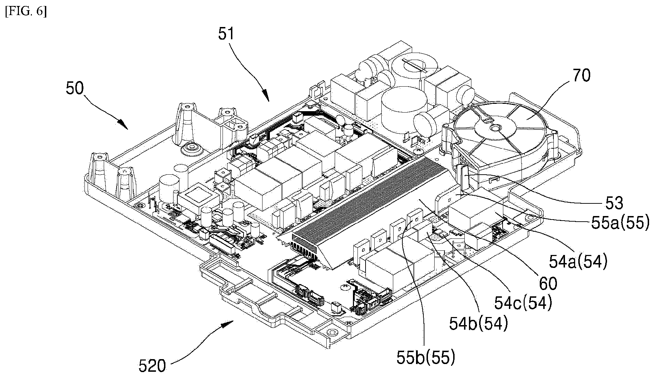

The air guide 80 may communicate with the air blower fan 70 and be provided with the air discharged from the air blower fan 70. The air guide 80 may be provided to surround the heat sink 60 and to further surround a first group of electronic devices 54, 55 (see FIG. 6, etc.) among the plurality of electronic devices. A air flow path may be formed inside the air guide 80 to cool the heat sink 60 and the first group of electronic devices 54, 55. Accordingly, the air discharged from the air blower fan 70 can flow along a flow path to cool the heat sink 60 and the first group of electronic devices 54, 55.

Referring to FIG. 5 , in order for the air forcibly moved by the air blower fan 70 to flow into the heat sink 60, a guide wall may be formed for guiding the flow of air in the direction in which the heat sink 60 is disposed at the exit of the air blower fan 70.

The detailed structure and function of the air guide 80 will be described in more detail below.

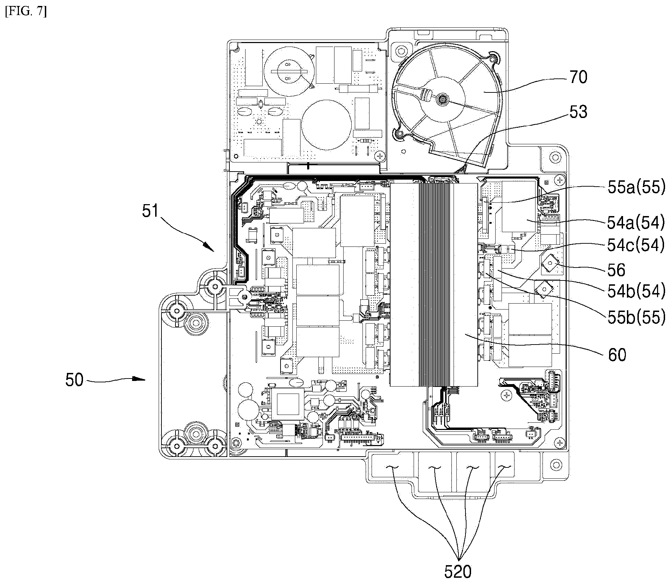

FIG. 6 is a perspective view illustrating a state in which the printed circuit board 51 is mounted on the base bracket 50 according to one embodiment. FIG. 7 is a plan view of FIG. 6.

Referring to FIGS. 6 and 7, the heat sink 60 and the plurality of electronic devices may be mounted on the printed circuit board 51. Additionally, the air blower fan 70 may be mounted on the base bracket 50.

The air blower fan 70 may be spaced from the rear side of the heat sink 60 and mounted on the base bracket 50. A lengthwise direction (that is, the frontward-rearward direction) of the heat sink 60 may be parallel with a direction in which air passing through the air guide 80 flows. Accordingly, a contact surface area and time for contact between the heat sink 60 and air forced to flow may increase, thereby enhance cooling efficiency of the heat sink 60.

A plurality of electronic devices may be disposed on the printed circuit board 51. The plurality of electronic devices may include a drive circuit that controls driving of the heater 30.

The drive circuit may include a rectifier, a DC link capacitor 54a, an inverter, a snubber, a capacitor 54b, an overcurrent protection circuit, a resonance capacitor, and a first terminal 56.

The rectifier may include a rectifying device 55a disposed on both sides of the heat sink 60. The rectifying device 55a may convert AC power supplied from an external power source into DC power. For example, the rectifying device 55a may include a bridge diode. The rectifying device 55a may be disposed on both sides of the heat sink 60.

The DC link capacitor 54a may receive DC power from the rectifying device 55a and reduce ripple in the supplied DC power. For example, the DC link capacitor 54a may be a smoothing capacitor.

DC voltage which is rectified by the rectifying device 55a and the ripple of which is reduced by the DC link capacitor 54a may be supplied to the inverter.

The inverter may include a plurality of inverter switching devices 55b disposed on both sides of the heat sink 60. The inverter switching devices 55b may be alternately turned on or turned off by a switching signal to convert DC power to high-frequency alternating current (that is, resonance current). The converted high-frequency alternating current may be supplied to the working coil through the first terminal 56.

For example, the inverter switching device 55b may include an insulated-gate bipolar transistor (IGBT).

A plurality of snubber capacitors 54b may be connected to the inverter. That is, each of the plurality of snubber capacitors 54b may be connected to the corresponding inverter switching device 55b. A plurality of snubber capacitors 54b may be disposed on both sides of the heat sink 60. The snubber capacitor 54b is provided to reduce power loss (i.e., power loss due to hard switching) that occurs when the inverter switching device 55b is turned off, and can also remove electromagnetic noise.

An overcurrent protection circuit may be provided to suppress overcurrent from flowing through the inverter switching device 55b. To do this, the overcurrent protection circuit may include a shunt resistor 54c.

A plurality of resonance capacitors may connect respectively to the plurality of inverter switching devices 55b in parallel. As voltage is supplied based on a switching operation of the inverter, the resonance capacitor starts to resonance. Accordingly, current flowing in the working coil increases, and eddy current is induced. Accordingly, the heater 30 may be driven.

Referring to FIGS. 5 to 7, the heat sink 60 and the first group of electronic devices 54, 55 may be disposed inside the air guide 80. Here, the first group of electronic devices 54, 55 may be defined as a group of electronic devices that generates heat above a preset critical temperature when driven. The first group of electronic devices 54, 55 includes some of the electronic devices 54 and other electronic devices 55.

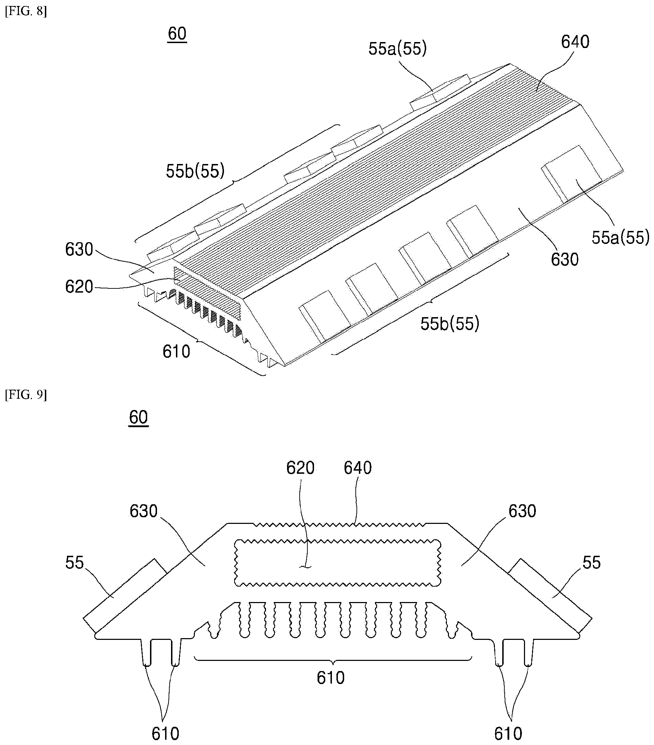

Some of the electronic devices 54 may include a DC link capacitor 54a, a snubber capacitor 54b, and a shunt resistor 54c. Some of other electronic devices 55 may be composed of other electronic devices 55 including a rectifying device 55a and an inverter switching device 55b. For example, some of other electronic devices 55 may be attached to the heat sink 60 (FIGS. 8 and 9) or may not be attached to the heat sink 60 (FIG. 6). When some of other electronic devices 55 are attached to the heat sink 60, cooling efficiency can be increased.

The heat sink 60 may be placed approximately at the center of the printed circuit board 51. The heat sink 60 may be mount behind the air blower fan 70.

Some of the electronic devices 54 may be mounted on the left side (third side) of the heat sink 60.

Specifically, a first electronic device among some of the electronic devices 54 corresponds to the DC link capacitor 54a and may be mounted at a first point of the printed circuit board 51. Here, the first point may be a point located on the left side (third side) of the heat sink 60 adjacent to the rear side (first side) of the heat sink.

Among some of the electronic devices 54, a second electronic device corresponds to the snubber capacitor 54b and may be mounted at a second point of the printed circuit board 51. Here, the second point may be a point located on the left side of the heat sink 60, which is closer to the front side (second side) of the heat sink 60 than the first point of the printed circuit board 51.

Among some of the electronic devices 54, a third electronic device corresponds to the shunt resistor 54c and can be mounted at a third point of the printed circuit board 51. Here, the third point may be a point located between the first point and second point of the printed circuit board 51.

FIG. 8 is a perspective view of the heat sink 60 according to an embodiment. FIG. 9 is a front view of the heat sink 60 according to an embodiment.

The heat sink 60 may be disposed in a longitudinal direction parallel to a flow direction of air passing through the air guide 80. Due to such structure, cooling efficiency of the heat sink 60 may be improved by increasing a contact area and a contact time between the heat sink 60 and air which is forcibly moved.

Meanwhile, the air guide 80 may also be disposed in a longitudinal direction substantially parallel to the flow direction of air to correspond to the above-described layout of the heat sink 60.

As illustrated in FIGS. 8 and 9, a plurality of cooling fins 610 may be provided on the heat sink 60. The plurality of cooling fins 610 may protrude from a lower surface of the heat sink 60 in the downward direction and may be formed parallel to the longitudinal direction of the heat sink 60. The cooling fins 610 may increase a contact area between the heat sink 60 and air to improve cooling efficiency of the heat sink 60.

The plurality of cooling fins 610 may be disposed on the lower surface of the heat sink 60 and spaced a proper interval from each other in a widthwise direction of the heat sink 60, respectively. In this case, the cooling fins 610 may be formed on an inclined portion 630 and flat portion 640 of the heat sink 60.

In addition, the heat sink 60 may include a flow pass 620 that passes through the heat sink 60 in the longitudinal direction and forms a flow path of air. The flow pass 620 may be formed in the longitudinal direction of the heat sink 60 to pass through the flat portion 640 of the heat sink 60.

The flow pass 620 may increase a contact area between the heat sink 60 and air like the cooling fin 610 to increase cooling efficiency of the heat sink 60. In this case, an irregular portion may be formed on an inner surface of the flow pass 620. The irregular portion may increase a contact area between the heat sink 60 and air to increase cooling efficiency of the heat sink 60.

The heat sink 60 may include the inclined portion 630 disposed at both sides and having an inclined upper surface and the flat portion 640 which is formed in a central portion, in which the flow pass 620 is formed, and an upper surface of which is formed as a flat surface.

An irregular portion may be formed on the upper surface of the flat part 640. The irregular portion may increase a contact area between the heat sink 60 and air to increase cooling efficiency of the heat sink 60.

Some of other electronic device 55 may be mounted on the inclined portion 630. That is, the plurality of the rectifying devices 55a and the plurality of inverter switching devices 55b may be attached to the inclined portion 630 of the heat sink 60. Accordingly, the air forced to flow by the air blower fan 70 can cool some of other electronic device 55 mounted on the inclined portion 630 of the heat sink 60. Accordingly, overheating of some of other electronic device 55 can be effectively suppressed.

The inclined portion 630 may have a structure whose thickness decreases toward an edge thereof. Accordingly, as the structure of the inclined portion 630 serves a function similar to that of the cooling fin 610, the electronic device 61 installed on the inclined portion 630 may be effectively cooled.

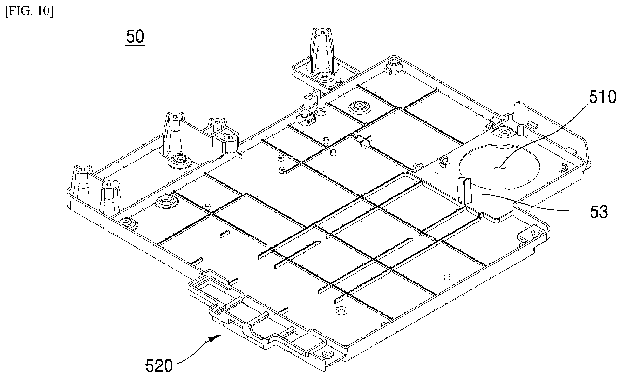

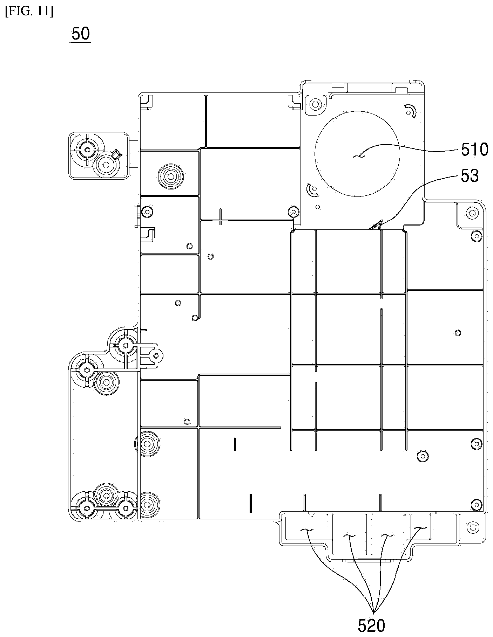

FIG. 10 is a perspective view of the base bracket 50 according to an embodiment. FIG. 11 is a plan view of the base bracket 50 according to an embodiment.

The base bracket 50 may include a first ventilation portion 510 formed in a portion corresponding to the air blower fan 70 and a second ventilation portion 520 formed in a portion corresponding to the front side of the air guide 80. In this case, the first ventilation portion 510 may be formed in a shape corresponding to a shape of the air blower fan 70, and the second ventilation portion 520 may be formed in a shape corresponding to a shape of the front side (i.e., outlet) of the air guide 80.

When the air blower fan 70 operates, air may flow upward from the first ventilation portion 510 and may flow into the air blower fan 70, a flow direction of the air may be changed by the air blower fan 70, and the air may flow in the frontward-rearward direction of the electric range to pass through the air guide 80.

The flow direction of the air may be changed at the exit of the air guide 80 again, and the air may flow in the downward direction of the electric range, may pass through the second ventilation portion 520, and may be discharged to the outside of the air guide 80.

Meanwhile, a pair of the inclined portion 630 of the heat sink 60 may be provided, and some of other electronic device 55 may be disposed on each of the inclined portions 630.

Due to this structure, some of other electronic devices 55 may be placed in symmetrical positions on both sides of the heat sink 60. In order to uniformly cool some of other electronic devices 55 disposed on both sides of the heat sink 60, it is necessary to guide the flow of air so that the air discharged from the exit of the air blowing fan 70 flows evenly on both sides of the heat sink 60.

Accordingly, in order for the air to uniformly flow to both sides of the heat sink 60, the electric range according to an embodiment may include a vane portion 53.

Referring to FIGS. 7, 10 and 11, the vane portion 53 may be disposed at a portion at which the air blower fan 70 communicates with the air guide 80, and the air guide 80 may control a flow direction of air so that the air uniformly flows to both sides of the heat sink 60.

For example, the vane portion 53 may be formed on the base bracket 50. As another embodiment, the vane portion 53 may be integrally formed with the air guide 80 at the entrance of the air guide 80. As still another embodiment, the vane portion 53 may also be integrally formed with a housing of the air blower fan 70 at the exit of the air blower fan 70.

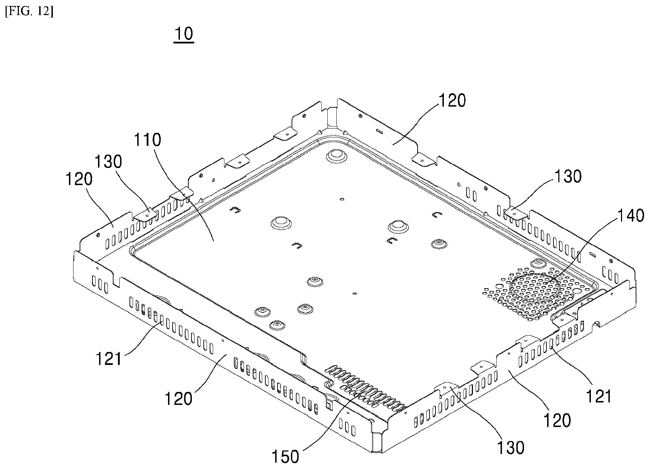

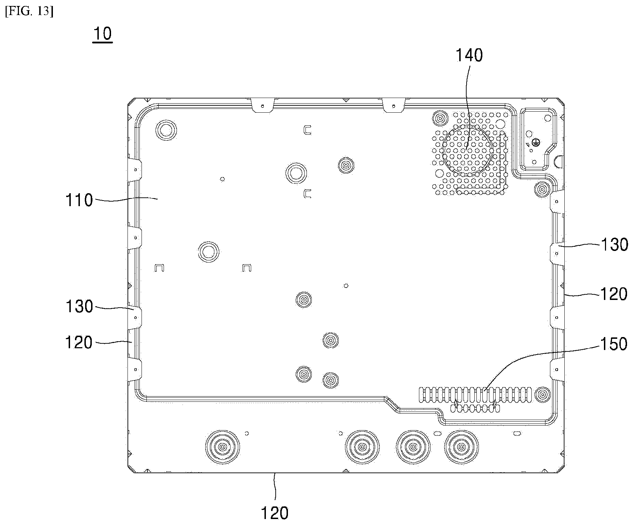

FIG. 12 is a perspective view of the case 10 according to an embodiment. FIG. 13 is a plan view of the case 10 according to an embodiment.

Referring to FIGS. 12 and 13, the case 10 may include a first through port 140 and a second through port 150 in order to allow air to be forcibly moved by the air blower fan 70 so that the air can effectively flow and be discharged.

The first through port 140 may be formed in a portion corresponding to the first ventilation portion 510, and the second through port 150 may be formed in a portion corresponding to the second ventilation portion 520. The first through port 140 and the second through port 150 may be formed by punching the first casing 110 forming the bottom surface of the case 10.

A plurality of the first through ports 140 and a plurality of the second through ports 150 may be provided. As the case 10 is an outermost wall of the electric range, the first through port 140 and the second through port 150 may be formed as holes having relatively small areas, but they are appropriately provided in plural numbers, in order to suppress external matter from flowing into the electric range through the first through ports 140 and the second through ports 150.

Hereinafter, the structure of the air guide 80 will be described in detail.

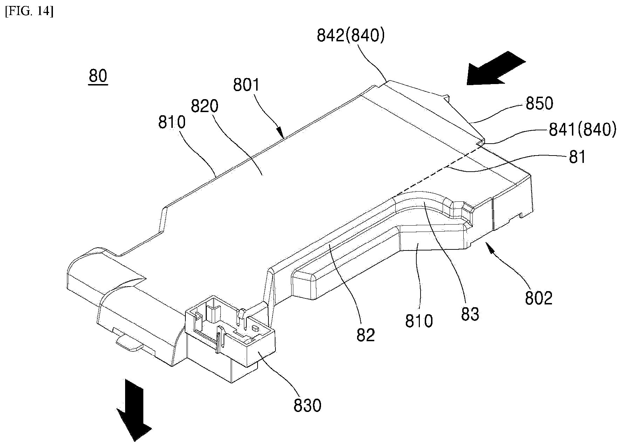

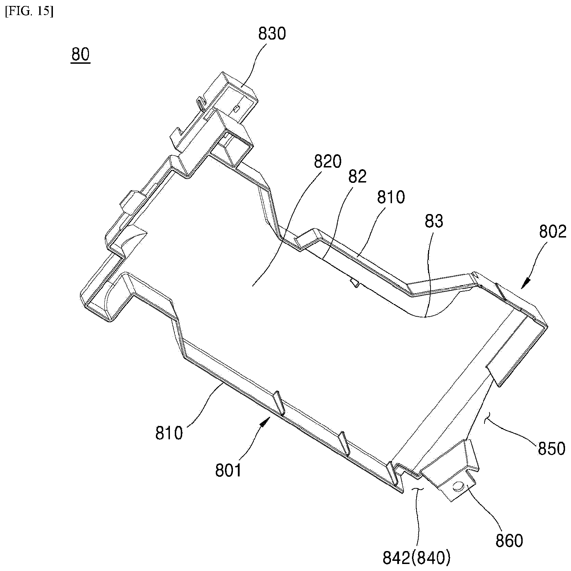

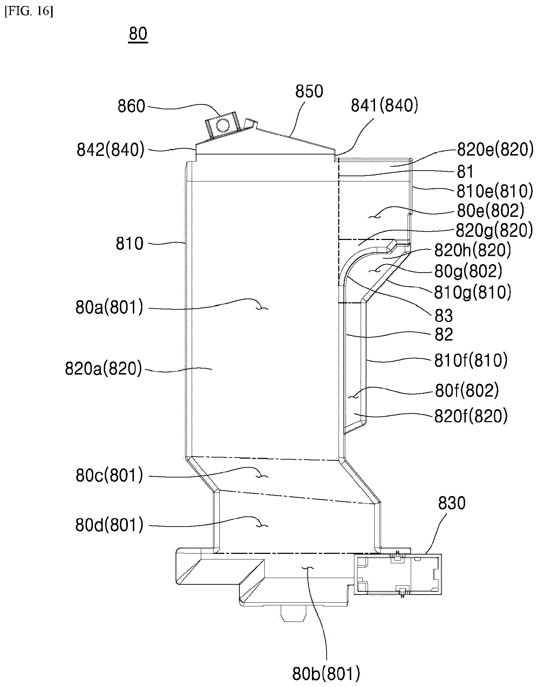

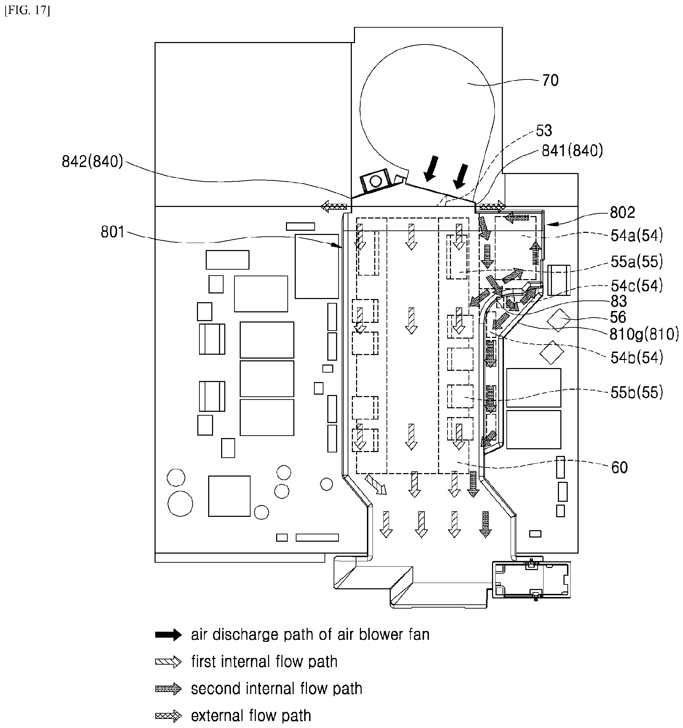

FIG. 14 is a perspective view of the air guide 80 according to an embodiment. FIG. 15 is a perspective view of FIG. 14 viewed from a different direction. FIG. 16 is a plan view of FIG. 14. FIG. 17 is a plan view illustrating the flow path of air inside and outside the air guide 80.

The air guide 80 may be provided to communicate with the air blower fan 70. The air guide 80 may be provided to surround the heat sink 60 and the first group of electronic devices 54, 55. A flow path of air that cools the heat sink 60 and the first electronic device 54, 55 may be formed inside the air guide 80.

As described above, some of the electronic devices 55 may not be attached to the heat sink 70, and some of other electronic devices 55 may be attached to the inclined surface 630 of the heat sink 60.

The air guide 80 may be made of plastics that ensures easy of injection molding and electrical insulation, but the material is not limited thereto.

The arrow illustrated in FIG. 14 may indicate the direction of air flow outside the air guide 80. Referring to FIG. 14, the air guide 80 may change the direction of air flow. That is, the air may flow in the frontward-rearward direction of the electric range at the entrance of the air guide 80, and the air may flow in the upward-downward direction of the electric range at the exit of the air guide 80.

With this structure, the air discharged from the air blower fan 70 may flow in the frontward-rearward direction of the electric range at the entrance of the air guide 80, and be discharged in a downward direction of the electric range at the exit of the air guide 80.

Meanwhile, the air guide 80 may be detachably coupled to the base bracket 50. For example, the rear side (i.e., inlet) of the air guide 80 into which the air discharged from the air blower fan 70 flows may be coupled to the base bracket 50 by a coupling tool, such as a screw bolt. Additionally, the front side (i.e., outlet) of the air guide 80, through which air is discharged, may be shape-fitted to the base bracket 50.

The air guide 80 may include a side wall 810 and an upper wall 820. A flow space in which air flows by the side wall 810 and the upper wall 820 may be formed in the air guide 80. That is, the flow space of the air guide 80 may be defined by the side wall 810 and the upper wall 820.

The side walls 810 may be provided as a pair disposed on the left and right sides of the heat sink 60, respectively. The upper wall 820 may be coupled to the upper end of the pair of side walls 810 and may be provided to cover the heat sink 60 and the first group of electronic devices 54, and may be bent at the front and rear sides of the air guide 80.

The heat sink 60 and some of the electronic devices 54 are disposed in the flow space of the air guide 80 and may be cooled by air flowing in the flow space.

Meanwhile, the air guide 80 may be provided with a communication board installation portion 830. The communication board installation portion 830 may be disposed in a portion that protrudes from an end portion of the upper bracket 40 laterally, in a state in which the air guide 80 is mounted onto the electric range.

A wireless communication circuit board mounted onto the communication board installation portion 830 may be disposed not to vertically overlap the upper bracket 40 made of metal. Accordingly, the wireless communication circuit board may smoothly communicate with an external device, without being interfered with by jamming of the upper bracket 40 made of metal.

Referring to FIGS. 14 and 16, the air guide 80 may be distinguished by a first part 801 and a second part 802. The first part 801 and second part 802 of the air guide 80 may be distinguished by a virtual plane 81. The first part 801 and second part 802 of the air guide 80 may be spaces into which the flow space of air, formed in the air guide 80, may be divided. Accordingly, the first part 801 and second part 802 of the air guide 80 may be in communication with each other.

The first part 801 of the air guide 80 may be a main part of the air guide 80. The first part of the air guide 80 may communicate with the air blower fan 70. The air blower fan 70 may discharge air toward the rear side (i.e., first side) of the heat sink 60.

The second part 802 of the air guide 80 may be a sub part of the air guide 80. The second part 802 of the air guide 80 may be formed to protrude from the left side of the first part 801 of the air guide 80.

Referring to FIG. 17, a first internal flow path may be formed in the first part 801 of the air guide 80, and a second internal flow path may be formed in the second part 802 of the air guide 80.

The first internal flow path and the second internal flow path may be included in the internal flow path of air flowing into the air guide 80. Here, based on the vane portion 53 and the inclined surface 63 on the left side of the heat sink 60, the internal flow path of air may be divided into the first internal flow path and the second internal flow path. Also, considering the location and shape of the vane portion 53, the amount of air flowing into the first internal flow path may be greater than the amount of air flowing into the second internal flow path.

The heat sink 60 may be disposed in the first part 801 of the air guide 80. Some of the air discharged toward the rear side of the heat sink 60 may flow into the first internal flow path. The air flowing through the first internal flow path can cool the heat sink 60 and some of other electronic devices 55 attached thereto.

A communication portion 850 and a guide coupling portion 860 may be formed in the first part 801 of the air guide 80.

The communication portion 850 may communicate with the exit of the air blower fan 70. The air forced to flow by the air blower fan 70 may flow into the inside the air guide 80 through the exit of the air blower fan 70 and the communication portion 850 and flow through the internal flow path.

The guide coupling portion 860 may protrude from the rear side of the air guide 80, and may couple the rear side of the air guide 80 to the base bracket 50. The guide coupling portion 860 may be mounted on the base bracket 50 using a coupling mechanism such as a screw bolt.

Meanwhile, referring to FIGS. 14 to 16, the first part 801 of the air guide 80 may further include an air discharge port 840.

The air discharge port 840 may discharge some of the air supplied to the entrance of the air guide 80 to the outside of the air guide 80. Referring to FIG. 17, some of the air discharged from the air discharge port 840 may flow to an external flow path and spread to the printed circuit board 51 located outside the air guide 80. Therefore, the air flowing through the external flow path can cool the electronic device mounted on the printed circuit board 51 located outside the air guide 80.

The air discharge port 840 may include a first outlet 841 formed on the right side of the communication portion 850, and a second outlet 842 formed on the left side of the communication portion 850.

The first outlet 841 may be disposed at a location connected to the communication portion 850. A portion of the second outlet 842 may be formed to be surrounded by the guide coupling portion 860. The first outlet 841 and the second outlet 842 may be formed so that the flow directions of air are opposite to each other, and may be formed in locations that are approximately symmetrical with respect to the guide coupling portion 860.

Some of the electronic devices among the plurality of electronic devices may be disposed in the second part 802 of the air guide 80. Some of the air discharged from the air blower fan 70 toward the rear side of the heat sink 60 may flow into the second internal flow path. The air flowing through the second internal flow path may cool some of the electronic devices 54.

Referring to FIG. 16, the first part 801 of the air guide 80 may include a first area 80a, a second area 80b, a third area 80c, and a fourth area 80d. The second part 802 of the air guide 80 may include a fifth area 80e, a sixth area 80f, and a seventh area 80g. The first to seventh areas 80a, 80b, 80c,80d, 80e, 80f, 80g may be the areas where the flow space of air generated in the air guide 80 is divided. Accordingly, the first to fourth areas 80a, 80b, 80c, 80d may be communicated to each other, and the fifth to seventh areas 80e, 80f, 80g may be communicated to each other.

In particular, the fifth to seventh areas 80e, 80f, 80g may be formed to protrude from the left side of the first area 80a. Accordingly, the first area 80a may be in communication with the fifth to seventh areas 80e, 80f, 80g.

Referring to FIGS. 16 and 17, the first internal flow path among the internal flow paths of the air guide 80 may be formed in the first to fourth areas 80a, 80b, 80c, 80d, and the second internal flow path among the internal flow paths of the air guide 80 may be formed in the fifth to seventh areas 80e, 80f, 80g. A The heat sink 60 to which some of other electronic devices 55 are attached may be disposed in the first to fourth areas 80a, 80b, 80c, 80d. Some of the electronic devices 54 may be disposed in the fifth to seventh areas 80e, 80f, 80g.

Hereinafter, the first to seventh areas 80a, 80b, 80c, 80d, 80e, 80f, 80g will be described in more detail.

The air discharge port 840, the communication portion 850, and the guide coupling portion 860 may be formed in the first area 80a. In this case, the heat sink 60 to which some of other electronic devices 55 are attached may be disposed in the first area 80a.

The air flowing into the air guide 80 from the air blower fan 70 flows through the heat sink 60 while passing through the first area 80a of the air guide 80, thereby cooling the heat sink 60 and some of other electronic devices 55.

The second area 80b may be bent in the upward-downward direction of the base bracket 50 and guide air to be discharged to the outside. The second area 80b is formed to face in downward direction of the electric range, so that the flow direction of air flowing into the air guide 80 can be changed.

That is, the upper wall 820 defining the second area 80b may be bent downward, and the air discharged from the second area 80b may be directed to the lower portion of the case 10.

Due to the above-described structure, as illustrated by the arrow in FIGS. 14, the air discharged from the air blower fan 70 may flow into the air guide 80 in the frontward-rearward direction of the electric range, and exit the air guide 80 in the downward direction of the electric range.

The third area 80c and the fourth area 80d may be provided between the first area 80a and the second area 80b.

The third area 80c may extend from the first area 80a, and change a flow direction of air having passed through the first area 80a. The side wall 810 defining the third area 80c may be bent from the end portion of the first area 80a to have a slant.

That is, the side wall 810 defining the third area 80c may be formed to be inclined with respect to a frontward-rearward direction of the air guide 80 at an entrance of the third area 80c of the air guide 80. Due to such structure, in the third area 80c, air may flow in a direction inclined with respect to the frontward-rearward direction of the air guide 80.

With this structure, when the air guide 80 is mounted onto the base bracket 50, in the portion overlapping with the air guide 80 in the upward-downward direction, interference between the electronic device mounted on the printed circuit board 51 and the side wall 810 can be avoided. That is, the third area 80c may have an inclined structure due to a structural need to avoid the devices mounted on the printed circuit board 51.

The fourth area 80d may extend from the third area 80c, communicate with the second area 80b, and change a flow direction of air having passed through the third area 80c. The side wall 810 defining the fourth area 80d may be bent from an end portion of the third area 80c to have a slant.

That is, at the exit of the third area 80c of the air guide 80, the side wall 810 defining the fourth area 80d may be formed to be inclined with respect to the side wall 810 defining the third area 80c.

With this structure, in the fourth area 80d, the air flow direction of the air guide 80 may be restored to the frontward-rearward direction of the air guide 80.

The air having passed through the fourth area 80d may be discharged from the lower portion of the electric range through the second area 80b. Referring to FIG. 16, the air having flown to the exit of the fourth area 80d in the air guide 80 in the frontward-rearward direction of the electric range changes its flow direction in the second area 80b, and flows to the lower portion of the electric range through the exit of the second area 80b and is discharged from the air guide 80.

The upper wall 820 defining the second area 80b may be bent from the front side of the second area 80b. Accordingly, the air discharged in the second area 80b may be directed to the lower portion of the case 10.

The fifth area 80e may be formed adjacent to the air blower fan 70 on the right side of the first area 80a. The side wall 810e of the fifth area 80e may be formed parallel to the side wall 810 defining the first area 80a. The upper wall 820e of the fifth area 80e may be formed at the same height as the upper wall 820a of the first area 80a. The upper wall 820e of the fifth area 80e may be bent at the rear side of the fifth area 80e. The first electronic device among some of the electronic devices 54 may be disposed in the fifth area 80e. The first electronic device may be the DC link capacitor 54a.

The sixth area 80f may be formed on the left side of the first area 80a and forward of the fifth area 80e. The side wall 810f of the sixth area 80f may be formed parallel to the side wall 810 defining the first area 80a, but may be formed to be inclined at the front side of the sixth area 80f. The second electronic device among some of the electronic devices 54 may be disposed in the sixth area 80e. The second electronic device may be the snubber capacitor 54b.

Referring to FIGS. 14 to 16, the sixth area 80f may be formed to be stepped from the first area 80a. That is, the upper wall 820a defining the first area 80a and the upper wall 820f defining the sixth area 80f may be connected by a first upper wall connection portion 82. The upper wall 820f defining the sixth area 80f may have a height lower than that of the upper wall 820a defining the first area 80a.

Due to this structure, when the air guide 80 is mounted on the base bracket 50, the device connected to the printed circuit board 51 may be prevented from interfering with the upper wall 820f defining the sixth area 80f.

That is, referring to FIG. 6 and FIGS. 14 to 16, the first terminal 56 connected to the working coil may be mounted on the left side of the air guide 80. Therefore, in order to avoid interference between the air guide 80 and the wire connected to the first terminal 56, the upper wall 820f of the sixth area 80f may be formed to be stepped from the upper wall 820a of the first area 80a.

The side wall 810f of the sixth area 80f may be bent to be inclined at an end portion of the sixth area 80f and connected to the side wall 810 defining the first area 80a.

The seventh area 80g may be formed on the left side of the first area 80a. The seventh area 80g may connect the fifth area 80e and the sixth area 80f. Among some of the electronic devices 54, the third electronic device and the remaining part of the second electronic device may be disposed in the seventh area 80g. The third electronic device may be the shunt resistor 54c.

Referring to FIGS. 14 to 16, the upper walls 820g, 820h of the seventh area 80g may include the upper wall 820g with a first height and the upper wall 820h with a second height. The upper wall 820g with the first height in the seventh area 80g and the upper wall 820h with the second height in the seventh area 80g may be connected by a second upper wall connection portion 83. However, the present disclosure is not limited thereto, and the seventh area 80g may include only the upper wall 820h with the second height.

The upper wall 820g with the first height in the seventh area 80g may have the same height as the upper wall 820a in the first area 80a and the upper wall 820f in the sixth area 80f. The upper wall 820h with the second height in the seventh area 80g may have the same height as the upper wall 820f in the sixth area 80f. That is, the upper wall 820h with the second height in the seventh area 80g may have a height lower than that of the upper wall 820g with the first height in the seventh area 80g.

The second upper wall connection portion 83 may have an inclined shape with respect to the side wall 810 defining the first area 80a. In particular, the second upper wall connection portion 83 may be inclined in a curved shape.

That is, the upper wall 820h with the second height in the seventh area 80g may be formed to be stepped from the upper wall 820a of the first area 80a. That is, a portion of the seventh area 80g may be formed to be stepped from the first area 80a. Through this, the generation of interference between the air guide 80 and the wire connected to the first terminal 56 can be avoided.

Meanwhile, the injection of the air guide 80 can be facilitated by forming the second upper wall connection portion 83 in a curved shape.

The side wall 810e of the fifth area 80e and the side wall 810f of the sixth area 80f may be connected through the side wall 810g of the seventh area 80g. In this case, the side wall 810g of the seventh area 80g may be formed to be inclined with respect to the side wall 810 defining the first area 80a.

Hereinafter, referring to FIG. 17, the flow of air discharged from the air blower fan 70 will be summarized.

The air blower fan 70 may discharge air toward the heat sink, and the discharged air may be introduced into the communication portion 850 of the air guide 80. In this case, due to the inclined shape of the vane portion 53 and heat sink 60, the introduced air may flow to the first internal flow path and second internal flow path of the air guide 80. Here, the first internal flow path may be formed in the first part 801 of the air guide 80, and the second internal flow path may be formed in the second part 802 of the air guide 80.

The air flowing through the first internal flow path may flow along the flow path 620, inclined portion 630, and flat portion 640 of the heat sink 60. Accordingly, the air flowing through the first internal flow path can cool the heat sink 60 and some of other electronic devices 55 attached thereto.

The air flowing through the second internal flow path may collide with some of electronic devices 54. Accordingly, the air flowing through the second internal flow path can cool some of electronic devices 54.

Specifically, some of the air flowing into the second internal flow path may collide with the side wall 810g of the inclined seventh area 80g and diverge in both directions. Some of the branched air may flow into the first internal flow path and the second internal flow path, and another portion of the branched air may flow into the fifth area 80e. That is, another portion of the branched air may flow in the reverse direction of the second internal flow path.

The air flowing in the reverse direction may flow to at least one of the left, upper, and rear sides of the DC link capacitor 54a. That is, air may flow throughout the fifth area 80e due to another portion of the branched air. Accordingly, the cooling efficiency of the DC link capacitor 54a can be increased.

In addition, some of the air flowing into the second internal flow path may collide with the inclined second upper wall connection portion 83 and diverge in both directions. Some of the branched air may flow into the first internal flow path, and another portion of the branched air may flow into the fifth area 80e. That is, another portion of the branched air may flow in the reverse direction of the second internal flow path.

The air flowing in the reverse direction may flow to the left, upper, and rear sides of the DC link capacitor 54a. In particular, due to the curved second upper wall connection portion 83, air turbulence may occur around the second upper wall connection portion 83. Accordingly, the cooling efficiency of the DC link capacitor 54a can be further increased by the air turbulence.

In addition, the end portion of the side wall 810g of the sixth area 80f is formed to be inclined, so that air flowing into the second internal flow path can flow naturally and cooling efficiency can be increased.

The air flowing into the second internal flow path may join at the end portion of the first area 80a and flow into the first internal flow path. Accordingly, high-temperature air that has cooled the heat sink 60, some electronic devices 54, and other electronic devices 55 may be discharged through the exit of the air guide 80.

Meanwhile, some of the air introduced based on the air discharge port 840 formed at the entrance of the air guide 80 may flow to the external flow path. The air flowing through the external flow path can cool the electronic devices mounted at points where the air guide 80 is not mounted.

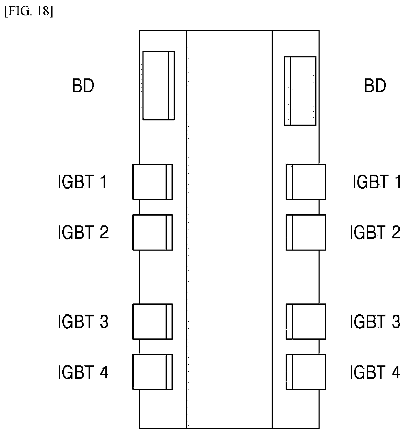

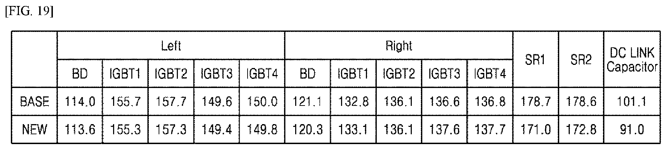

Hereinafter, the temperature distribution of electronic devices cooled through air flowing in the air guide 80 will be described with reference to FIGS. 18 and 19.

FIG. 18 is a plan view of the heat sink 60 used in the simulation of the present disclosure.

Referring to FIG. 18, some of other electronic devices 55 are attached to the inclined surfaces 630 on both sides of the heat sink 60. Here, some of other electronic devices 55 include a pair of bridge diodes (BD), which are the rectifier devices 55a, and four pairs of IGBTs, which are the inverter switching devices 55b.

Meanwhile, the three heaters 30 operate, the air blower fan 70 discharges air into the air guide 80 for 840 seconds at a rotation speed of 3300 rpm, and an object to be heated is an oil load.

FIG. 19 shows simulation results of the present disclosure. In FIG. 19, a reference electric range with an air guide in which only the first part 801 exists and the electric range of the present disclosure with the air guide 80 in which both the first part 801 and the second part 802 exist were compared.

Referring to FIG. 19, in the case of the present disclosure, the temperatures of the diode (BD) and IGBT do not show a significant difference. However, it can be seen that the temperature of the DC link capacitor 54a and the shunt resistor 54c is significantly lower than that of the reference electric range.

Briefly, according to the present disclosure, by forming separate air flow paths in each of the heat sink 60 and some of electronic devices 54 present inside the air guide 80, the electronic devices where overheating mainly occurs can be effectively cooled, and eventually overheating of the printed circuit board 51 can be effectively suppressed.

In addition, according to the present disclosure, by forming a portion of the side wall of the second internal flow path of air that cools some of the electronic devices 54 to be inclined, air can effectively flow into the second internal flow path, and thus the cooling efficiency of some of the electronic device 54 can be increased.

In addition, according to the present disclosure, interference with other components mounted on the printed circuit board 51 can be prevented by forming the second internal flow path of air that cools some of the electronic devices 54 in a stepped manner. Accordingly, the efficiency of assembly can be increased.

The present disclosure has been described with reference to the embodiments illustrated in the drawings. However, the disclosure is not limited to the embodiments and the drawings set forth herein. Further, various modifications may be made by one having ordinary skill in the art within the scope of the technical spirit of the disclosure. Further, though not explicitly described during description of the embodiments of the disclosure, effects and predictable effects according to the configuration of the disclosure should be included in the scope of the disclosure.

## Claims

1. An electric range, comprising:
a printed circuit board on which a plurality of electronic devices is mounted;
a heat sink which is mounted on the printed circuit board;
an air blower fan which discharges air; and
an air guide which surrounds some electronic devices from among the plurality of electronic devices and the heat sink, communicates with the air blower fan, and forms a flow path of the air discharged from the air blower fan,
wherein the flow path of the air includes a first flow path which cools the heat sink and a second flow path which cools the some electronic devices.

2. The electric range of claim 1, wherein the air blower fan discharges the air toward a first side of the heat sink,
a portion of the air discharged toward the first side of the heat sink flows into the first flow path,
another portion of the air discharged toward the first side of the heat sink flows into the second flow path.

3. The electric range of claim 2, further comprising a vane portion which is disposed at a portion where the air blower fan and the air guide communicate, and guides the flow path of the air discharged from the air blower fan,
wherein the flow path of the air is divided into the first flow path and the second flow path based on the vane portion.

4. The electric range of claim 1, wherein the some of electronic devices include a first electronic device,
the first electronic device is mounted on a first point of the printed circuit board,
the first point of the printed circuit board is a point located in a direction of a third side of the heat sink adjacent to a first side of the heat sink,
the air is discharged from the air blower fan toward the first side of the heat sink,
the third side of the heat sink is a side perpendicular to the first side of the heat sink.

5. The electric range of claim 1, further comprising:
an upper bracket which supports a heater; and
a base bracket which is disposed on a lower portion of the upper bracket and on which the printed circuit board and the air blower fan are installed.

6. The electric range of claim 4, wherein the some of electronic devices include a second electronic device,
the second electronic device is mounted on a second point of the printed circuit board,
the second point of the printed circuit board is a point located in a direction of the third side of the heat sink, which is closer to a second side of the heat sink than the first point of the printed circuit board.

7. The electric range of claim 6, wherein the second electronic device is a snubber capacitor which is used to derive a heater.

8. The electric range of claim 6, wherein the some of electronic devices include a third electronic device,
the third electronic device is mounted on a third point of the printed circuit board,
the third point of the printed circuit board is a point located between the first point of the printed circuit board and the second point of the printed circuit board.

9. The electric range of claim 8, wherein the third electronic device is a shunt resistor which is used to drive a heater.

10. The electric range of claim 1, wherein the heat sink is disposed so that a longitudinal direction of the heat sink is parallel to the first flow path,
some others of the plurality of electronic devices are attached to an outer surface of the heat sink,
the some others of the electronic devices are cooled by the air flowing through the first flow path.

11. An electric range, comprising:
a base bracket on which a printed circuit board equipped with an electronic device is installed;
a heat sink which is mounted on the printed circuit board;
an air blower fan which is installed on the base bracket and discharges air; and
an air guide which surrounds the electronic device and the heat sink, communicates with the air blower fan, and forms a flow path of the air discharged from the air blower fan,
wherein the air guide includes a first part and a second part protruding from one side of the first part,
the heat sink is disposed on the first part, and the electronic device is disposed on the second part.

12. The electric range of claim 11, wherein a communication portion communicating with an exit of the air blower fan is formed in the first part, and the second part is formed to communicate with the first part on one side of the first part.

13. The electric range of claim 12, wherein the first part includes:
a first area in which the communication portion is formed;
a second area which is bent in an upward-downward direction of the base bracket and guides the air to be discharged to an outside;
a third area which extends from the first area and changes a flow direction of the air passing through the first area;
a fourth area which extends from the third area, communicates with the second area, and changes the flow direction of the air passing through the third area.

14. The electric range of claim 12, wherein the electronic device includes a first electronic device, a second electronic device and a third electronic device,
the second part of the air guide includes:
a fifth area which is formed adjacent to the communication portion and on which the first electronic device is disposed;
a sixth area on which a portion of the second electronic device is disposed;
a seventh area which connects the fifth area and the sixth area and on which a remaining portion of the second electronic device and the third electronic device are disposed.
the fifth, sixth and seventh areas are in communication with each other,

15. The electric range of claim 14, wherein the first part includes a first area in which the communication portion is formed,
the fifth, sixth and seventh areas are formed to be protruded from one side of the first area,
the sixth and seventh areas are formed to be stepped from the first area.

16. The electric range of claim 14, wherein the air guide includes a pair of side walls, and an upper wall coupled to an upper end of the pair of side walls,
each of the first part and the second part is defined by a portion of the side walls and a portion of the upper wall, respectively.

17. The electric range of claim 16, wherein the side wall defining the fifth area and the side wall defining the sixth area are connected through the side wall defining the seventh area,
the side wall defining the seventh area is formed to be inclined.

18. The electric range of claim 16, wherein the side wall defining the sixth area is bent from an end portion of the sixth area to be inclined and is connected to the side wall defining the first area.

19. The electric range of claim 16, wherein at least a portion of the upper wall defining the sixth area has a height lower than the upper wall defining the first part, and is connected to the upper wall defining the first part through a upper wall connection portion.

20. The electric range of claim 19, wherein the upper wall connection portion has a curved and inclined shape.
